Europäisches Patentamt

European Patent Office

Office européen des brevets

(19)

(11) Numéro de publication: **0 322 695 B1**

(12) **FASCICULE DE BREVET EUROPEEN**

(45) Date de publication de fascicule du brevet: **03.03.93** (51) Int. Cl.⁵: **G06F 1/02**, H03K 3/78, G06F 7/62

(21) Numéro de dépôt: **88121207.0**

(22) Date de dépôt: **19.12.88**

(54) **Générateur de signal temporel périodique à caractère récursif.**

(30) Priorité: **21.12.87 FR 8717810**

(43) Date de publication de la demande:
**05.07.89 Bulletin 89/27**

(45) Mention de la délivrance du brevet:
**03.03.93 Bulletin 93/09**

(84) Etats contractants désignés:
**CH DE FR GB IT LI NL SE**

(56) Documents cités:
DE-A- 2 618 823
GB-A- 2 176 678

L'ONDE ELECTRIOUE, vol. 58, no. 11, novembre 1978, pages 747-756; P. MINOT:
"Séquences anharmoniques"

(73) Titulaire: **ALCATEL ALSTHOM COMPAGNIE
GENERALE D'ELECTRICITE
54, rue La Boétie
F-75382 Paris Cédex 08(FR)**

(72) Inventeur: **Le Mehaute, Alain
3 Route de Belleville
F-91190 Gif sur Yvette(FR)**
Inventeur: **Ouiniou, Jean-François
120 rue de Belfort
F-25000 Besancon(FR)**
Inventeur: **Roques-Carmes, Claude
6 rue Saint Just
F-25000 Besancon(FR)**
Inventeur: **Wehbi, Dalloul
12 rue Sainte Claire Deville
F-25000 Besancon(FR)**
Inventeur: **Derossis, Antoine
35 rue Moutard Martin
F-91460 Marcoussis(FR)**

(74) Mandataire: **Weinmiller, Jürgen et al
Lennéstrasse 9 Postfach 24
W-8133 Feldafing (DE)**

EP 0 322 695 B1

**Description**

La présente invention concerne les signaux temporels périodiques dont la configuration sur une période est définie par un arrangement de motifs précurseurs de différents types résultant d'une construction récursive mettant en oeuvre plusieurs applications successives de lois récurrentes de composition de types de motif définies chacune par un arrangement spécifique de p types de motif éventuellement identiques. D'une manière générale, la configuration sur une période d'un signal temporel résultant de ce genre de construction récursive peut être considérée comme une composante "an" du n ième terme Un à m composantes (an, bn, cn...), une par type de motif, d'une suite récurrente, ce n ième terme étant défini au niveau de ses composantes (an, bn, cn...) en fonction des composantes (an-1, bn-1, cn-1...) du terme précédent Un-1 par les lois récurrentes de composition de types de motif et le terme initial Uo de la suite ayant pour composantes (ao, bo, co...) les motifs précurseurs.

Le processus de construction récursive permet d'accroître la complexité du motif obtenu d'une manière extrêmement rapide d'une itération à l'autre. Grâce à lui, on obtient en peu d'itérations un motif de signal présentant l'apparence générale d'un signal aléatoire alors qu'il est en fait très structuré et possède des propriétés de similitude interne indépendantes du facteur d'échelle.

En raison de ces caractéristiques, le signal temporel résultant présente d'intéressantes applications dans diverses techniques telles que celles des tests vibratoires, des transducteurs et stimulateurs, de fabrication de macromolécules cantoriennes par électrosynthèse et, de façon générale, de quasi-cristaux... Les signaux temporels connus sous le nom de "fractal" résultent d'une construction récursive de ce genre, mais la construction décrite ici est plus générale.

On connaît déjà du document DE 26 18 823 un générateur de signaux pseudo-aléatoires utilisant des registres à décalage. Ce générateur ne s'applique pas aux fractals. Le document GB 21 76 678 A divulgue une méthode de génération de signaux vidéo représentant graphiquement des fractals, mais ce document n'apporte pas de solution pour concevoir un générateur de fractals.

La présente invention a pour but un générateur de signal temporel permettant d'engendrer avec une grande rapidité des signaux du type précité. Ce but est atteint selon l'invention par le générateur tel que défini dans la revendication principale. En ce qui concerne des exemples préférés de mise en oeuvre, référence est faite aux revendications secondaires.

L'invention sera décrite ci-après plus en détail à l'aide de plusieurs modes de réalisation donnés à titre d'exemple. Cette description sera faite en regard du dessin dans lequel

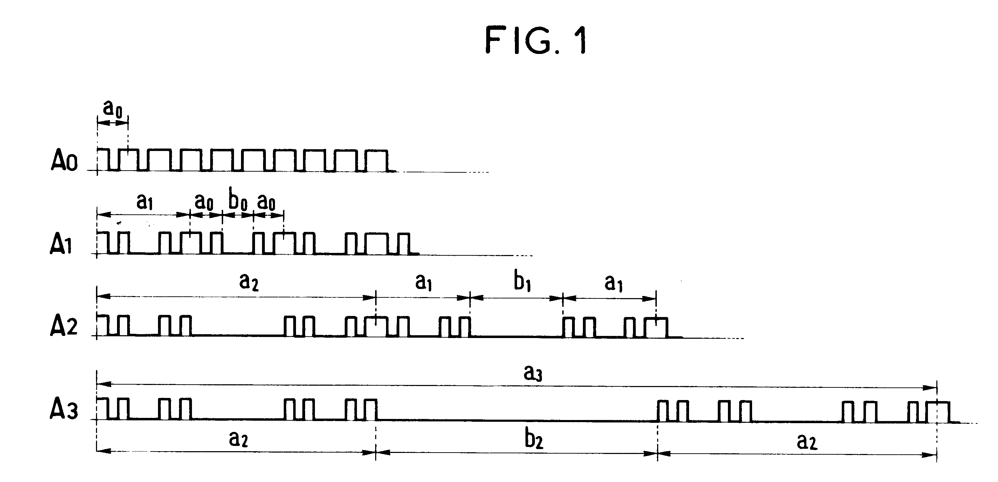

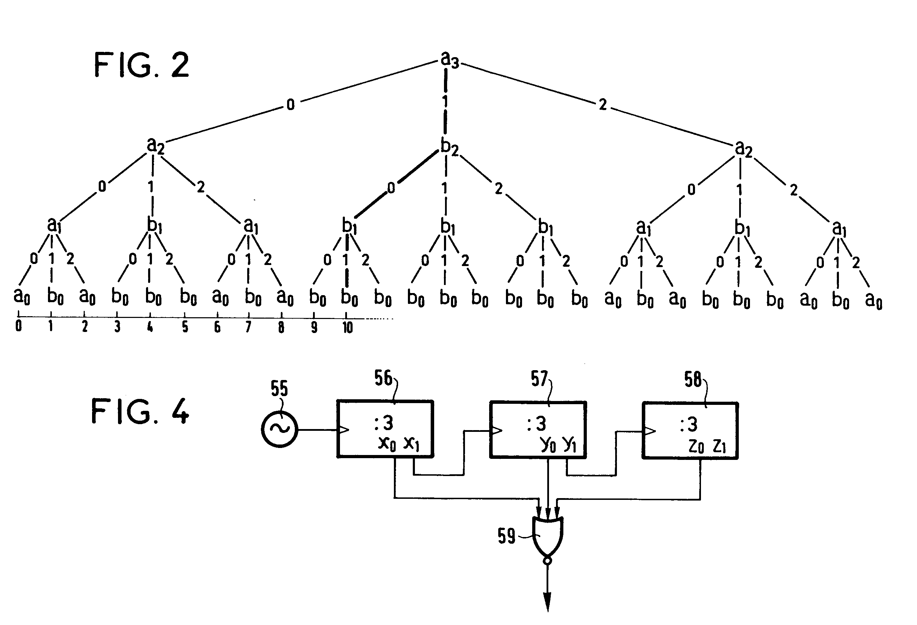

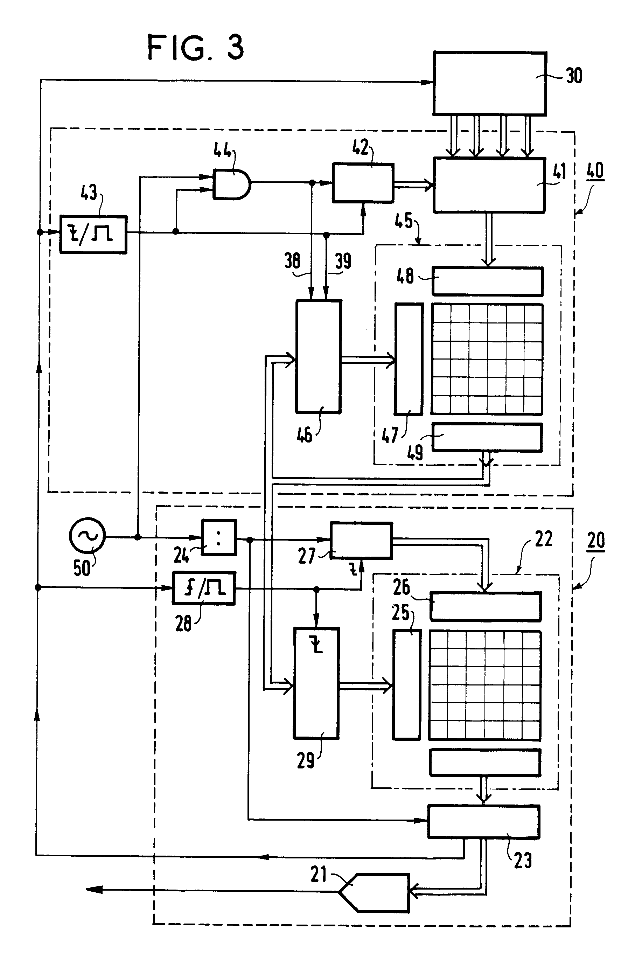

- la figure 1 est un diagramme de courbe illustrant sur des exemples de signaux l'accroissement extrêmement rapide de la complexité du motif sur une période obtenue par le processus de construction : itérative,
- une figure 2 représente la construction arborescente menant aux formes de signaux représentées à la figure 1,
- une figure 3 représente un schéma bloc d'un générateur de signal conforme à l'invention utilisant une logique séquentielle
- et une figure 4 représente le schéma d'un générateur de signal conforme à l'invention utilisant une logique câblée.

La figure 1 donne un exemple de définition d'un signal binaire temporel par l'intermédiaire d'une suite "an" de valeurs qui représente un échantillonnage régulier de l'une de ses périodes et qui est obtenue par une construction arborescente mettant en oeuvre deux motifs précurseurs :

ao = 1 0 1
bo = 0 0 0

associés à deux lois de composition de types de motif :

an = an-1 bn-1 an-1
bn = bn-1 bn-1 bn-1

Chaque i ème étape de la construction aboutissant à la définition du motif "ai" nécessite la connaissance du couple de motifs a (i-1) b (i-1) obtenu à l'étape antérieure qui peut être considéré comme les composantes d'un terme Ui-1 d'une suite récurrente comprenant 3 éléments de motif ayant un terme initial Uo composé des motifs précurseurs ao, bo, formés eux mêmes de 3 élements.

Dans le cas présent, les deux lois de composition adoptées permettent de définir la période du signal binaire à partir du motif élémentaire 1 0 1 à la manière dont CANTOR fait ses découpages géométriques

2

EP 0 322 695 B1

ou diadiques (of B. Mandelbrot "the geometry of the nature" Freedman-1982) et d'obtenir un signal fractal.

La courbe Ao représente le signal temporel ayant pour configuration périodique le motif précurseur ao. C'est un signal rectangulaire périodique régulier formé d'impulsions de rapport 2.

La courbe A1 représente le signal temporel ayant pour configuration périodique le motif a1 déduit des motifs précurseurs ao, bo après une application des lois de composition de types de motif :

$$a1 = ao\ bo\ ao$$
$$= 1\ 0\ 1\ 0\ 0\ 0\ 1\ 0\ 1$$

$$a2 = a1\ b1\ a1 = ao\ bo\ ao\ bo\ bo\ bo\ ao\ bo\ ao$$
$$= 1\ 0\ 1\ 0\ 0\ 0\ 1\ 0\ 1\ 0\ 0\ 0\ 0\ 0\ 0\ 0\ 1\ 0\ 1\ 0\ 0\ 0\ 1\ 0\ 1$$

Ce signal est un signal binaire légèrement irrégulier, avec des impulsions de largeur unitaire et de largeur double et une période trois fois plus longue que le précédent.

La courbe A2 représente le signal temporel ayant pour configuration périodique le motif a2 déduit des motifs précurseurs ao, bo par une double application des lois de composition récurrentes :

Ce signal est un signal binaire nettement plus irrégulier que le précédent avec des impulsions pour la plupart de largeur unitaire.

La courbe A3 représente le signal temporel ayant pour configuration périodique le motif a3 déduit des motifs précurseurs ao. bo par une triple application des lois de composition de types de motif :

$$a3 = a2\ b2\ a2$$
$$= a1,\ b1,\ a1,\ b1,\ b1,\ b1,\ a1,\ b1,\ a1$$
$$= ao\ bo\ ao\ \ bo\ bo\ bo\ \ ao\ bo\ ao\ \ bo\ bo\ bo\ bo\ bo\ bo\ bo\ bo$$
$$bo\ \ ao\ bo\ ao...$$

C'est un signal binaire encore plus irrégulier que le précédent ayant une période trois fois plus longue que celui-ci.

A chaque nouvelle application des lois de composition des éléments de motif le nombre d'éléments des motifs triple. Cette loi de croissance lui permet d'atteindre rapidement des valeurs très élevées puisqu'à la treizième application des lois de récurrence de types de motif il vaut déjà :

$$3^{14} = 4\ 782\ 969$$

ce qui correspond pour un signal temporel défini par des échantillons se succédant à la cadence de un par seconde, à une période de durée supérieure à mille heures (un mois). Un tel signal a l'apparence d'un signal aléatoire alors qu'il est très structuré et formé d'impulsions présentant une organisation cantorienne ayant des propriétés de similitude interne quelle que soit l'échelle d'analyse temporelle qui le rendent particulièrement utile dans divers techniques telles que la fabrication de macromolécules fractales par électrosynthèse, des matériaux métalliques ou céramiques sous vibrations, les tests vibratoires en mécanique destinés à prévoir les comportements à long terme de certains matériaux, par exemple les surfaces de frottement, l'excitation des transducteurs et stimulateurs ainsi que toutes techniques faisant appel classiquement à des considérations spectrales et de corrélation.

La figure 2 illustre la construction récursive menant à la décomposition en motifs précurseurs ao, bo du motif a3 du signal A3 de la figure 1. Le motif a3 commence par être décomposé en motifs a2, b2 en application de la loi récurrente de composition de motif de type a. Il vient :

$$a3 = a2\ b2\ a2$$

Les motifs a2 b2 sont alors eux mêmes décomposés en motifs a1, b1 en application des lois récurrentes de composition des motifs de types a et b de sorte qu'il vient :

3

a3 = a1 b1 a1 b1 b1 b1 a1 b1 a1

Les motifs a1 b1 sont enfin décomposés en motifs précurseurs ao bo par une nouvelle application des lois récurrentes de composition des motifs de types a et b pour aboutir au résultat final :

$$a3 = \text{ao bo ao bo bo bo ao bo ao bo bo bo bo bo bo bo bo bo ao}$$
$$\text{bo ao bo bo bo ao bo ao}$$

On constate que si l'on numérote les motifs précurseurs ao bo dan leur ordre d'apparition dans le motif a3 et si l'on exprime le nombre obtenu en base 3 avec trois chiffres, on obtient un repérage du cheminement menant, dans la construction arborescente du motif a3, au motif précurseur considéré en désignant de la gauche vers la droite les trois branches de la première ramification par les valeurs 0, 1 et 2 du chiffre le plus significatif, les trois branches de chaque deuxième ramification par les valeurs 0, 1 et 2 du chiffre intermédiaire et les trois branches de chaque troisième ramification par les valeurs 0, 1 et 2 du chiffre de moindre poids. Ainsi, le motif précurseur bo intervenant en dixième position a un ordre qui s'exprime en base 3 par 101 :

$$(10)_{10} = (101)_3$$

et s'obtient en suivant le cheminement repéré en traits plus gras allant de a3 à b2 choisi en raison de la valeur 1 du chiffre le plus significatif de son ordre exprimé en base 3 puis celui allant de b2 à b1 choisi en raison de la valeur 0 du chiffre intermédiaire de son ordre exprimé en base 3 et enfin celui allant de b1 à bo choisi en raison de la valeur 1 du chiffre le plus faible de son ordre exprimé en base 3. Le suivi de ce cheminement ne nécessite pas la connaissance de la topographie générale de la construction arborescente car le repérage des branches au niveau de chaque embranchement coïncide avec le rang compté à partir de zéro du type de motif du point d'arrivée dans la loi récurrente de composition du type de motif de l'embranchement. Ainsi, le premier segment du cheminement menant au type de motif précurseur intervenant en dixième position dans la décomposition du motif a3 a pour point de départ le motif a3 et pour point d'arrivée le motif b2 car la dixième position s';exprime en base 3 par le nombre à trois chiffres :

$$(10)_{10} = (101)_3$$

ayant pour chiffre le plus significatif la valeur 1 qui désigne le type de motif d'arrivée comme étant celui apparaissant au deuxième rang dans la loi récurrente de composition du type de motif d'origine ici a :

$$an = an\text{-}1 \; bn\text{-}1 \; an\text{-}1$$

Le deuxième segment du cheminement a donc pour point de départ le motif b2. Son point d'arrivée est le motif b1 car le chiffre médian du nombre en base 3 exprimant la dizième position est 0 et désigne le type de motif d'arrivée comme celui apparaissant au premier rang dans la loi récurrente de composition du type de motif d'origine ici b :

$$bn = bn\text{-}1 \; bn\text{-}1 \; bn\text{-}1$$

Le troisième segment du cheminement a alors pour point de départ le motif b1. Son point d'arrivée est le motif bo car le chiffre le moins significatif du nombre en base 3 exprimant la dixième position est 1 et désigne le type de motif d'arrivée comme celui apparaissant au deuxième rang de la loi récurrente de composition de type de motif d'origine ici b :

$$bn = bn\text{-}1 \; bn\text{-}1 \; bn\text{-}1$$

On peut donc déterminer le type d'un motif précurseur intervenant dans la décomposition du motif a3 à partir de la connaissance de son ordre dans cette décomposition et de celles des lois récurrentes de composition de types de motif. D'une manière plus générale, cela reste vrai lorsque les lois récurrentes de composition de types de motif s'expriment toutes par des arrangements d'un même nombre p de types de motif, certains types de motif pouvant être répétés, la détermination faisant alors intervenir l'expression de

4

l'ordre de la position du motif précurseur dont on cherche le type par un nombre de base p à n chiffres, n étant l nombre d'applications des lois récurrentes de composition de type de motif ou encore le nombre d'étages de la construction arborescente.

La figure 3 montre le schéma d'un générateur de signal utilisant cette manière de faire. Ce générateur peur se décomposer en un circuit d'élaboration de formes élémentaires des signaux correspondant aux formes de définition des différents types de motifs précurseurs 20, en un compteur en base p à n chiffres 30 incrémenté à chaque nouvelle forme élémentaire de signal délivrée par le circuit d'élaboration de formes 20, en un circuit de sélection de types de motifs précurseurs 40 piloté par le compteur 30 et contrôlant le circuit d'élaboration de formes 20, et un oscillateur 50 délivrant la cadence d'échantillonnage du signal fourni par le générateur et contrôlant la succession des opérations séquentielles de recherche menées par le circuit de sélection de types de motifs précurseurs 40.

Le circuit d'élaboration de formes 20 renferme, en sortie, un convertisseur numérique-analogique 21 qui délivre le signal de sortie du générateur et reçoit des valeurs d'échantillonnage lues dans une mémoire morte 22 par l'intermédiaire d'un premier ensemble de registres tampon 23 inscrit régulièrement au rythme d'échantillonnage du signal de sortie fourni par un circuit diviseur 24 excité par l'oscillateur 50.

Le convertisseur numérique-analogique 21 est éventuellement équipé en sortie d'un interface de puissance permettant d'adapter les caractéristiques du signal délivré à celles demandées par l'utilisation.

La mémoire morte 22 stocke des suites de valeurs d'échantillonnage qui peuvent avoir différentes longueurs et qui définissent les formes élémentaires de signaux correspondant aux différents types de motif précurseur, chaque valeur étant complétée par un bit de contrôle au niveau logique 1 lorsqu'il s'agit d'une dernière valeur d'une suite. Son adressage est à deux entrées : une entrée dite d'adressage lignes 25 qui permet de sélectionner une suite de valeurs d'échantillonnage correspondant à un type quelconque de motif précurseur et une entrée dite d'adressage colonnes 26 qui permet de sélectionner un rang quelconque de valeurs d'échantillonnage dans les différentes suites. L'entrée d'adressage colonnes 26 est balayée régulièrement par un compteur d'adresses 27 qui est incrémenté par le circuit diviseur 24 fournissant le rythme d'échantillonnage du signal de sortie et qui est remis à zéro à la fin de chaque suite de valeurs d'échantillonnage par l'intermédiaire d'un circuit temporisateur 28 déclenché par le passage au niveau logique 1 du bit de contrôle lu en sortie de l'ensemble de registres tampon 23. L'entrée d'adressage lignes 25 est commandée par un deuxième ensemble de registres tampon 29 qui échantillonne le signal de sortie du circuit de sélection de type de motifs précurseurs 40 aux instants de remise à zéro du compteur d'adresses 27 sous le contrôle du circuit temporisateur 28.

Le compteur 30 en base p à n chiffres est incrémenté au rythme de passage au niveau logique 1 du bit de contrôle lu en sortie de l'ensemble de registres tampon 23 et exprime ainsi en un nombre p à n chiffres, l'ordre de succession des motifs précurseurs dans le signal de sortie du générateur.

Le circuit de sélection de types de motif précurseur 40 comporte un convertisseur parallèle-série mettant sous une forme série le nombre à n chiffres délivré sous forme parallèle par le compteur en base p 30 et délivrant successivement ces n chiffres, dans un ordre de poids décroissants et sur une durée un peu inférieure à celle du type de motif précurseur le plus court, à un circuit de logique séquentielle reconstituant le cheminement à suivre dans la construction arborescente pour déterminer le prochain type de motif précurseur à faire engendrer par le circuit d'élaboration de formes 20.

Le convertisseur parallèle-série comprend un multiplexeur 41 à n entrées de données, une sortie de données et une entrée d'adressage, un compteur d'adresses 42 connecté à l'entrée d'adressage du multiplexeur 41 de manière à provoquer, lors de son incrémentation, un balayage successif des n entrées de données du multiplexeur 41 dans un ordre correspondant à celui des poids décroissants pour les n chiffres du nombre délivré par le compteur en base p 30, un monostable 43 qui est déclenché par les passages au niveau logique o du bit de contrôle sur une durée un peu inférieure à celle du type de motif précurseur le plus court et maintient le compteur d'adresse 42 à zéro en dehors de ses périodes de déclenchement, et une porte 44 intercalée entre l'oscillateur 50 et le compteur d'adresses 42 et commandée à l'ouverture par le déclenchement du monostable 43. La fréquence de l'oscillateur 50 et le rapport du circuit diviseur 24 sont choisis de manière qu'un train de n-1 impulsions apparaisse à l'entrée du compteur d'adresses 42 à chaque déclenchement du monostable 43.

Le circuit de logique séquentielle comprend essentiellement une mémoire morte 45 à adressage partiellement bouclé par l'intermédiaire d'un troisième ensemble de registres tampon 46.

La mémoire morte 45 stocke m suites qui sont composées de p données pouvant prendre chacune m valeurs distinctes et qui correspondent aux m arrangements spécifiques de p types de motifs définissant les lois récurrentes de composition, chaque donnée dans une suite identifiant un type de motif apparaissant au même rang dans l'arrangement correspondant. Son adressage est à deux entrées : une entrée dite d'adressage lignes 47 permettant de sélectionner les m suites une par une et une entrée dite d'adressage

EP 0 322 695 B1

colonnes 48 permettant de sélectionner les données apparaissant à un rang déterminé dans les suites. L'entrée d'adressage colonnes 48 est contrôlée par la sortie de données du multiplexeur 41 tandis que l'entrée d'adressage lignes 47 est adressé par une donnée lue précédemment et stockée temporairement dans le troisième ensemble de registres tampon 46.

Le troisième ensemble de registres tampon 46 intercalé entre l'entrée d'adressage lignes 48 de la mémoire 45 et la sortie lecture de données 49 de cette dernière est pourvu d'une commande de prépositionnement 39 couplée à la commande de remise à zéro du compteur d'adresses 42 et d'une commande d'inscription 38 connectée en sortie de la porte 44.

Chaque impulsion d'incrémentation du compteur d'adresses 42 correspond à la fin de la détermination d'un segment du cheminement dans la construction arborescente menant au prochain type de motif précurseur à faire engendrer par le circuit d'élaboration de formes 20.

En dehors de la fenêtre temporelle définie par le monostable 43 où apparaissent ces impulsions, la mémoire 45 est adressée pour déterminer le premier segment du cheminement, le troisième ensemble de registres tampon 46 étant prépositionné pour adresser dans cette dernière, la suite de données correspondant à l'arrangement spécifique de la loi récurrente de composition du type du motif "an" définissant la période du signal à engendrer.

Pendant cette fenêtre temporelle, avant l'apparition de la première impulsion d'incrémentation du compteur d'adresses 42, la mémoire 45 reçoit en adressage colonnes 48 le chiffre de plus fort poids du nouveau nombre établi par le compteur en base p 30 ce qui entraîne la sélection dans la suite correspondant à la loi récurrente du type de motif "an" présélectionnée par l'adressage ligne, de la donnée correspondant au type du motif de destination du premier segment du cheminement. A l'apparition de la première impulsion d'incrémentation, la mémoire 45 a ses adressages lignes et colonnes modifiés pour déterminer le deuxième segment du cheminement, son adressage lignes recevant la valeur de la donnée précédemment lue pour sélectionner la suite de données correspondant à la loi récurrente du type du motif d'origine de ce deuxième segment et son adressage colonnes recevant le chiffre de poids immédiatement inférieur du nombre du compteur en base p 30 pour sélectionner dans cette suite la donnée correspondant au type du motif d'arrivée du deuxième segment du cheminement. A l'apparition des impulsions d'incrémentation suivantes, le processus de détermination des segments du cheminement se poursuit jusqu'à obtenir, après la n-1 ième et dernière impulsion d'incrémentation du compteur d'adresses 42, le type du motif précurseur à faire engendrer par le circuit d'élaboration de forme 20 qui est mis en mémoire par le deuxième ensemble de registres tampon 29 en fin de processus.

Dans les cas de configuration périodiques simples qui mettent en oeuvre un faible nombre de motifs précurseurs de types peu nombreux correspondant à des formes élémentaires simples, il est possible de réduire le circuit d'élaboration de formes et celui de sélection de motifs précurseurs à un simple circuit logique câblé. La figure 4 illustre un circuit de ce genre pour la mise en oeuvre de la construction arborescente à trois niveaux de la figure 2 avec un type de motif précurseur a correspondant à une forme de signal définie par un seul échantillon de niveau logique 1 et un type de motif précurseur b correspondant à une forme de signal définie par le niveau logique o et l'obtention d'un signal dont la configuration périodique correspond à la courbe A2 de la figure 2.

La construction arborescente à trois niveaux de la figure 2 étant définie par les lois récurrentes de composition de types de motif :

a = a b a
b = b b b

comportant des arrangements de trois motifs, le cheminement pour connaître le type d'un motif précurseur à engendrer 1 ou o, est déterminé en exprimant l'ordre d'apparition du motif dans la configuration en un nombre à base trois à trois chiffres que l'on peut repérer par ordre de poids croissants par les lettres x, y, z et qui s'expriment chacun en binaire par deux composantes xo, x1 ; yo, y1 ; zo, z1, l'indice o repérant le poids binaire o et l'indice 1 le poids binaire 1. En remarquant que dans la construction arborescente, tous les cheminements empruntant des segments d'embranchement médian aboutissent à des motifs précurseurs dont les ordres s'expriment par un nombre à base trois à trois chiffres ayant au moins l'une des composantes xo, yo, zo au niveau logique 1 et que tous ces cheminements et seuls cas cheminements aboutissent à des motifs précurseurs de type o, on s'aperçoit que le type de motif précurseur à engendrer correspond à la valeur de la relation logique :

xo + yo + zo

6

Le circuit de la figure 4 met en oeuvre cette façon de faire. Il comporte un oscillateur 55 attaquant un diviseur par trois à trois étages 56, 57, 58. Le premier étage 56 délivre sur deux sorties parallèles les composantes xo, x1 du chiffre de plus faible poids et est relié par sa sortie x1 à l'entrée d'incrémentation du deuxième étage 57. Ce dernier délivre sur deux sorties parallèles les composantes yo, y1, du chiffre intermédiaire et est relié par sa sortie y1 à l'entrée d'incrémentation du troisième étage 58 qui délivre sur deux sorties parallèles les composantes zo, z1 du chiffre de plus fort poids. Une porte logique de type "non ou" à trois entrées 59 réunit les sorties xo, yo et zo des trois étages 56, 57, 58 du diviseur par trois et délivre sur sa sortie un signal dont la configuration périodique correspond à la courbe A2 de la figure 1.

Ce circuit qui engendre un signal binaire ayant une période limitée à 27 éléments binaires $(3^3)$ peut facilement être modifié pour engendrer un signal binaire de période beaucoup plus longue puisqu'il suffit d'augmenter le nombre d'étages de son diviseur par trois et le nombre d'entrée de sa porte logique de type "non ou". Avec trois étages du plus, on obtient déjà un signal binaire ayant une période de 729 éléments binaires $(3^6)$.

On peut, sans sortir du cadre de l'invention modifier certaines dispositions ou remplacer certains moyens par des moyens équivalents. On peut notamment faire réaliser les fonctions des différents circuits décrits à l'aide d'un microprocesseur associé à des mémoires de programme et de travail et à différents périphériques permettant à la fois sa programmation et l'élaboration du signal.

Il va de soi que le générateur de signaux récursif peut être fabriqué selon une technique entièrement de type "hardware" toujours plus rapide qu'une technique microprocesseur.

**Revendications**

1.  Générateur de signal temporel périodique à caractère récursif dont le motif de configuration périodique est défini par un arrangement de motifs précurseurs (ao, bo, ...) de m types différents (a, b, ...), m étant un entier plus grand que 1, résultant d'une construction récursive mettant en oeuvre n applications successives de m lois récurrentes de composition de type de motif définies chacune par un arrangement de p types de motif, p étant un entier plus grand que 1, ladite construction récursive consistant à définir le motif de configuration périodique comme l'une des composantes du nième terme Un à m composantes (an, bn, ...), un par type de motif, d'une suite récurrente, ledit nième terme Un étant défini au niveau de ses composantes (an, bn, ...) en fonction des composantes (an-1, bn-1, ...) du terme précédent Un-1 par les m lois récurrentes de composition de type de motif et le terme initial Uo de la suite ayant pour composantes les motifs précurseurs (ao, bo, ...), le générateur comportant des moyens de décomposition du motif de configuration périodique en une succession de motifs précurseurs (ao, bo, ...) et des moyens (20) d'élaboration des formes de signal correspondant aux différents motifs précurseurs apparaissant dans la succession, lesdits moyens de décomposition du motif de configuration périodique comportant:
    -   des moyens de comptage en base p (30) qui sont incrémentés au rythme des changements de motifs précurseurs dans la décomposition du motif de configuration périodique et qui délivrent un nombre à n chiffres,
    -   et des moyens de sélection de types de motif (40) qui sont adressés par les moyens de comptage en base p (30).

2.  Générateur selon la revendication 1, caractérisé en ce que lesdits moyens de sélection de types de motif (40) comportent :
    -   des moyens de mémorisation (45) stockant dans un tableau à deux dimensions m suites de p données correspondant aux m arrangements de p types de motif définissant les lois récurrentes, et comportant une entrée d'adressage lignes (47) permettant de sélectionner l'une quelconque des m suites et une entrée d'adressage colonnes (48) permettant de sélectionner une donnée apparaissant à un rang déterminé dans la suite présélectionnée par l'adressage lignes (47),
    -   des moyens de conversion parallèle série (41) mettant sous forme série le nombre délivré par le compteur en base p (30) et appliquant successivement les chiffres de ce nombre, par ordre des poids décroissants, à l'entrée d'adressage colonnes (48) des moyens de mémorisation (45) et
    -   des moyens de bouclage (46) transmettant la donnée disponible en lecture dans les moyens de mémorisation (45) à l'entrée d'adressage lignes (47) de ces mêmes moyens de mémorisation (45) avec un temps de retard par rapport aux applications successives à l'entrée d'adressage colonnes (48), des chiffres du nombre délivré par le compteur en base p (30).

**3.** Générateur selon la revendication 1, caractérisé en ce que les moyens de sélection de types de motif sont réalisés à l'aide de circuits de logique câblée (59).

## Claims

**1.** A recursive periodic temporal signal generator wherein the periodic configuration pattern is defined by an arrangement of seed patterns (a0, b0, ...) of m different types (a, b, ...) where m is an integer greater than one, resulting from a recursive construction employing n successive applications of m recurrent pattern type composition laws defined by an arrangement of p pattern types where p is an integer greater than one, said recursive construction consisting in defining the periodic configuration pattern as one of the components of the nth term Un with m components (an, bn, ..), one per pattern type, of a recurrent sequence, said nth term Un being defined at the level of its components (an, bn, ..) according to the components (an-1, bn-1, ...) of the preceding term Un-1 by the m recurrent pattern type composition laws and the initial term U0 of the sequence having for its components the seed patterns (a0, b0, ..), said generator comprising means for breaking down the periodic configuration pattern into a sequence of seed patterns (a0, b0, ..) and means (20) for generating signal forms corresponding to the various seed patterns appearing in the sequence, said means for breaking down the periodic configuration pattern comprising:

- counting means (30) to base p which are incremented when the seed patterns change in the breakdown of the periodic configuration pattern and which deliver an n-digit number, and
- pattern type selector means (40) addressed by the counting means (30) to base p.

**2.** A generator according to claim 1, characterized in that said pattern type selector means (40) comprise:

- memory means (45) storing in a two-dimensional array m sequences of p data items corresponding to the m arrangements of pattern types defining the recurrent laws, and having a row addressing input (47) for selecting any one of the m sequences and a column addressing input (48) for selecting a data item occurring at a particular rank in the sequence preselected by the row addressing input (47),
- parallel-serial conversion means (41) for serializing the number delivered by the counter (30) to base p and applying the digits of this number successively in decreasing weight order to the row addressing input (48) of the memory means (45), and
- loop means (46) for transmitting the data available in read mode from the memory means (45) to the row addressing input (47) of the memory means (45) with a time-delay relative to the successive applications to the column addressing input (48) of the digits of the number delivered by the counter (30) to base p.

**3.** Generator according to claim 1, characterized in that the pattern type selector means are implemented using wired logic circuits (59).

## Patentansprüche

**1.** Generator für ein periodisches Zeitsignal mit rekursiver Eigenschaft, dessen periodisches Konfigurationsmotiv durch eine Anordnung von Präkursormotiven (ao, bo, ...) m verschiedener Typen (a, b, ..) definiert ist, wobei m eine ganze Zahl größer als 1 ist, und das aus einer rekursiven Konstruktion resultiert, die n aufeinanderfolgende Anwendungen von m rekursiven Kompositionsgesetzen von Motivtypen erfordert, die je durch eine Anordnung von p Motivtypen definiert sind, wobei p eine ganze Zahl größer als 1 ist, wobei die rekursive Konstruktion darin besteht, das periodische Konfigurationsmotiv als eine der Komponenten des n-ten Terms Un einer rekursiven Folge bestehend aus m Komponenten (an, bn, ...) zu definieren, und zwar eine Term pro Motivtyp, wobei der n-te Term Un in Höhe seiner Komponenten (an, bn, ..) abhängig von den Komponenten (an-1, bn-1, ...) des vorhergehenden Terms Un-1 aufgrund der m rekursiven Kompositionsgesetze für Motivtypen definiert ist und der Ursprungsterm Uo der Folge die Komponenten der Präkursormotive (ao, bo, ...) besitzt, wobei der Generator Mittel zur Zerlegung des periodischen Konfigurationsmotivs in eine Folge von Präkursormotiven (ao, bo, ..) und Mittel (20) zur Ausarbeitung von den verschiedenen in der Folge auftretenden Präkursormotiven entsprechenden Signalformen besitzt, wobei die Mittel zur Zerlegung des periodischen Konfigurationsmotivs aufweisen:

- Mittel (30) zum Zählen im Zahlensystem p, die im Rhythmus der Wechsel von Präkursormotiven bei der Zerlegung des periodischen Konfigurationsmotivs weitergezählt werden und eine Zahl mit n Ziffern liefern,

- und Mittel (40) zur Motivtypenauswahl, die von den Zählmitteln im Zahlensystem p (30) adressiert werden.

2. Generator nach Anspruch 1, dadurch gekennzeichnet, daß die Mittel zur Motivauswahl (40) aufweisen:

- Speichermittel (45), die in einer zweidimensionalen Tabelle m Folgen von p Angaben entsprechend den m Anordnungen von p die rekursiven Gesetze definierenden Motivtypen speichern und einen Zeilenadresseingang (47) zur Auswahl einer beliebigen der m Folgen und eine Spaltenadresseingang (48) zur Auswahl einer Angabe aufweisen, die in einem bestimmten Rang in der durch die Zeilenadressierung (47) vorausgewählten Folge auftritt,
- Mittel zur Parallel-Serienumwandlung (41), die die von dem Zähler (30) im Zahlensystem p gelieferte Zahl in Serienform umwandelt und nacheinander die Ziffern dieser Zahl mit fallender Wichtung an den Spaltenadresseingang (48) der Speichermittel (45) anlegt,
- und Schleifenmittel (46), die die beim Auslesen der Speichermittel (45) verfügbare Angabe an den Zeilenadresseingang (47) dieser Speichermittel (45) mit einer Verzögerung bezüglich der aufeinanderfolgenden Anlage der Ziffern der vom Zähler (30) im Zahlensystem p gelieferten Zahl an den Spaltenadresseingang (48) überträgt.

3. Generator nach Anspruch 1, dadurch gekennzeichnet, daß die Auswahlmittel für Motivtypen mit Hilfe von verdrahteten logischen Schaltkreisen (59) implementiert sind.

# FIG. 1

EP 0 322 695 B1

FIG. 2

FIG. 4

EP 0 322 695 B1

# FIG. 3